# FASCICULE DE BREVET EUROPEEN

(11) **EP 2 325 878 B1**
(45) Date de publication et mention de la délivrance du brevet: **29.05.2013**
(21) Numéro de dépôt: 10189174.5
(22) Date de dépôt: 28.10.2010
(51) Int. Cl.: H01L 21/98, H01L 25/065, H01L 21/56, H01L 23/31

(54) **Procédé d'encapsulation de composants électroniques avant découpe de la tranche**
Verfahren zur Verkapselung elektronischer Bauelemente vor Waferzerteilung
Wafer-scale encapsulation process of electronic devices

(30) Priorité: 20.11.2009 FR 0958225
(43) Date de publication de la demande: 25.05.2011
(73) Titulaire: STMicroelectronics (Tours) SAS, 37100 Tours (FR)
(72) Inventeur: Feron, Marc, 75006 Paris (FR); Jarry, Vincent, 37390 La Membrolle Sur Choisille (FR); Barreau, Laurent, 37130 Cinq Mars La Pile (FR)
(74) Mandataire: de Beaumont, Michel

(56) Documents cités:
- WO-A2-2008/087578
- US-A1- 2004 145 051
- US-A1- 2005 167 798
- US-A1- 2006 046 438
- US-A1- 2006 063 312
- US-A1- 2009 181 519
- US-A1- 2009 215 227

## Description

### Domaine de l'invention

La présente invention concerne un procédé d'encapsulation, avant découpe, de composants électroniques formés sur une tranche semiconductrice. Elle concerne plus particulièrement un procédé d'encapsulation de composants électroniques sur lesquels sont reportées des puces électroniques.

### Exposé de l'art antérieur

Pour fabriquer une puce électronique encapsulée, on forme un grand nombre de composants électroniques identiques dans et sur une tranche semiconductrice. Un ou plusieurs niveaux d'interconnexion sont ensuite formés au-dessus des composants électroniques pour connecter les éléments de ces composants entre eux et à des plots de connexion. Il peut également être prévu de reporter des puces électroniques en surface de l'empilement d'interconnexion, sur des plots d'accrochage adaptés. Une fois ces étapes réalisées, le dispositif est encapsulé puis est découpé en puces individuelles.

Pour encapsuler des composants électroniques directement sur la tranche dans laquelle ils sont formés, les procédés connus prévoient des étapes intermédiaires de collage de tranches semiconductrices, encore appelées poignées, au moins d'un côté de la structure. Les poignées sont utilisées pour rigidifier la structure lors des différentes étapes d'encapsulation et lors d'étapes d'amincissement de la tranche semiconductrice dans laquelle sont formés les composants.

Un inconvénient des procédés connus est que l'utilisation de ces poignées est relativement coûteuse et contraignante. En effet, les poignées sont des tranches épaisses semiconductrices ou en verre qui se dégradent par suite des opérations de collage et de décollage.

Les documents US 2005/167798 et US 2006/046438 décrivent des procédés de formation de composants électroniques sur des tranches semiconductrices.

Un besoin existe donc d'un procédé d'encapsulation de composants électroniques, sur lesquels peuvent être fixées des puces rapportées, ne nécessitant pas l'utilisation de poignées semiconductrices tout en évitant les phénomènes de gauchissement.

### Résumé

Un objet d'un mode de réalisation de la présente invention est de prévoir un procédé d'encapsulation de composants électroniques formés dans et sur une tranche semiconductrice, directement sur cette tranche.

Un autre objet d'un mode de réalisation de la présente invention est de prévoir un procédé adapté à l'encapsulation de composants électroniques sur lesquels sont fixées des puces rapportées.

Un autre objet d'un mode de réalisation de la présente invention est de prévoir un procédé évitant les problèmes de gauchissement de la structure avant découpe.

Ainsi, un mode de réalisation de la présente invention prévoit un procédé d'encapsulation de composants électroniques selon la revendication 1, comprenant les étapes suivantes :
(a) former, dans et sur une première face d'une tranche semiconductrice, des composants électroniques ;
(b) former, sur la première face, un empilement d'interconnexion comprenant des pistes et vias conducteurs séparés par un matériau isolant ;
(c) former des premiers et deuxièmes plots d'accrochage sur l'empilement d'interconnexion ;
(d) amincir la tranche semiconductrice, excepté au moins sur son contour ;
(e) remplir la région amincie d'une première couche de résine ;
(f) reporter au moins une puce sur les premiers plots d'accrochage et former des billes de soudure sur les deuxièmes plots d'accrochage ;
(g) déposer une seconde couche de résine recouvrant les puces et recouvrant partiellement les billes de soudure ;
(h) coller une bande adhésive sur la première couche de résine ; et
(i) découper la structure en puces individuelles. Le mode de réalisation de la présente invention selon la revendication 1 étant tel que :
l'étape (a) comprend en outre la formation de tranchées remplies de matériau conducteur du côté de la première face de la tranche semiconductrice ;
l'étape (d) est prévue pour laisser apparaître la face inférieure desdites tranchées ; et
l'étape (d) est suivie d'une étape de formation de troisièmes plots d'accrochage sur la tranche semiconductrice, au niveau des tranchées remplies de matériau semiconducteur et d'une étape de report de puces sur les troisièmes plots d'accrochage.

Les revendications dépendantes décrivent des modes de réalisation privilégiés de la présente invention.

Selon un mode de réalisation privilégié de la présente invention, la première couche de résine contient des charges d'un diamètre inférieur à 20 µm.

Selon un mode de réalisation privilégié de la présente invention, les puces sont fixées sur les régions d'accrochage correspondantes par des secondes billes de soudure.

Selon un mode de réalisation privilégié de la présente invention, les secondes billes de soudure ont un diamètre compris entre 20 et 100 µm.

Selon un mode de réalisation privilégié de la présente invention, les premiers, deuxièmes et troisièmes plots d'accrochage sont constitués d'un empilement conducteur.

Selon un mode de réalisation privilégié de la présente invention, l'étape (i) est suivie d'un décollage de la bande adhésive.

### Brève description des dessins

Ces objets, caractéristiques et avantages, ainsi que d'autres seront exposés en détail dans la suite de la description.

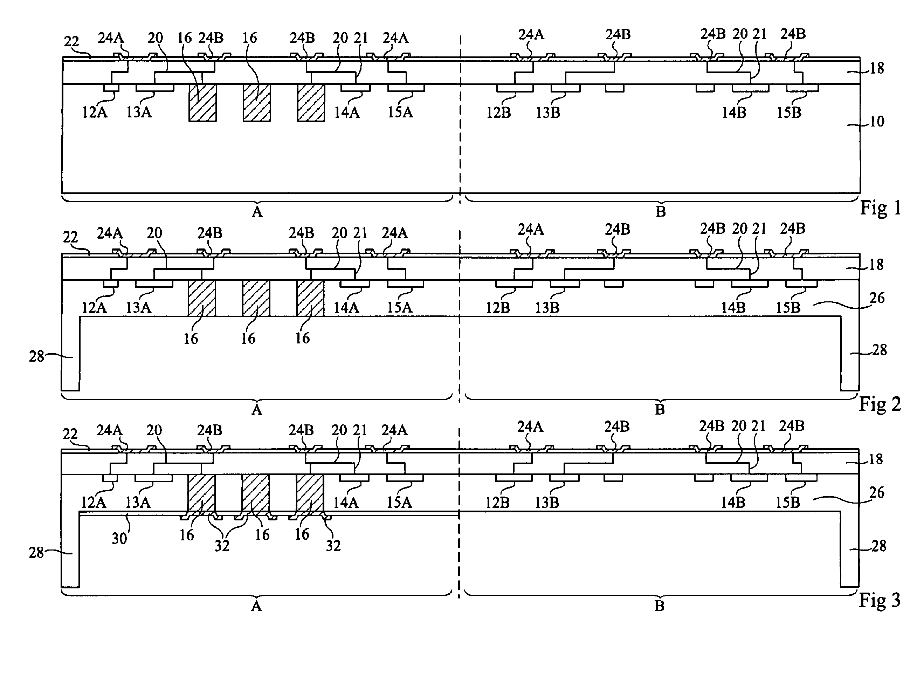

Les figures 1 à 6 sont des vues en coupe illustrant des résultats d'étapes d'un procédé selon un mode de réalisation de la présente invention et d'un procédé selon un exemple utile à la compréhension de la présente invention.

Par souci de clarté, de mêmes éléments ont été désignés par de mêmes références aux différentes figures et, de plus, comme cela est habituel dans la représentation des composants électroniques sur tranche, les diverses figures ne sont pas tracées à l'échelle.

### Description détaillée

Pour éviter l'utilisation de poignées lors des étapes d'encapsulation de composants électroniques sur tranche et les phénomènes de gauchissement de la structure, les inventeurs prévoient un procédé mettant en oeuvre des couches de résine rigide et des poutres de renforcement de la structure.

Les figures 1 à 6 sont des vues en coupe illustrant des résultats d'étapes d'un procédé d'encapsulation permettant l'obtention de puces encapsulées destinées à être fixées par leurs faces avant, c'est-à-dire du côté de la face de la tranche semiconductrice où sont formés les composants électroniques. Le procédé décrit ici est particulièrement adapté à la formation de puces électroniques encapsulées de type à montage en surface (SMT).

Dans les figures, deux variantes de réalisation A et B du procédé sont représentées : dans la variante A, des puces sont reportées sur les deux faces de composants électroniques formés dans une tranche semiconductrice tandis que, dans la variante B, des puces sont reportées uniquement sur la face supérieure de cette tranche semiconductrice. On notera que l'objet des revendications concerne la variante A.

A l'étape illustrée en figure 1, commune aux deux variantes A et B, on part d'une structure comprenant une tranche semiconductrice épaisse 10, encore appelée substrat, par exemple en silicium, dans et sur laquelle sont formés des composants électroniques. La tranche 10 peut avoir une épaisseur comprise entre 500 et 900 µm. On notera que le choix des composants représentés dans et sur la tranche semiconductrice 10 est tout à fait arbitraire, et que tout composant électronique pourra être formé en surface de la tranche 10. De plus, contrairement à ce qui est représenté dans les figures, de nombreux composants électroniques sont formés les uns à côtés des autres dans la tranche semiconductrice 10. En particulier, on pourra prévoir des composants de puissance ou de protection. De plus, contrairement à ce qui est représenté dans les figures, de nombreux composants électroniques sont formés les uns à côtés des autres dans la tranche semiconductrice 10. La partie de tranche représentée est légèrement supérieure à l'étendue d'un composant électronique.

Dans la variante A, au niveau de chaque composant électronique, sont formées, dans la tranche semiconductrice 10, des tranchées 16 remplies d'un matériau conducteur. Les tranchées 16 sont destinées à constituer des vias à travers le substrat (TSV, de l'anglais "through silicon via"), une fois une étape d'amincissement de la tranche semiconductrice 10 réalisée. Pour cela, les tranchées 16 sont relativement profondes, par exemple de 100 à 200 µm. Les structures de via TSV étant connues par ailleurs, leur formation ne sera pas décrite ici plus en détail. Une fine couche isolante est formée sur les parois des tranchées 16.

En surface de la tranche semiconductrice 10 est formé un empilement d'interconnexion 18. Cet empilement comprend un ou plusieurs niveaux d'interconnexion, non représentés en détail, dans lesquels sont formées des pistes conductrices 20 connectées entre elles, et aux composants électroniques, par des vias conducteurs 21. Les pistes et les vias conducteurs sont schématisés par des traits horizontaux 20 et des traits verticaux 21 et sont entourés d'un matériau isolant. Des pistes et vias conducteurs sont également prévus jusqu'au contact des tranchées conductrices 16 dans le cas de la variante A.

En surface de l'empilement d'interconnexion 18 est formée une couche isolante 22 comprenant des ouvertures de connexion avec des puces rapportées et avec des billes de soudure. Des régions conductrices d'accrochage ou plots 24A et 24B, destinées à améliorer la connexion avec des éléments de connexion des puces rapportées (24B) ou des billes de soudure (24A), sont formés au niveau des ouvertures dans la couche 22. Les plots 24A et 24B sont par exemple constitués d'un empilement de régions métalliques d'accrochage de billes de soudure (UBM), un tel empilement comprenant au moins une couche inférieure permettant une bonne adhérence sur des pistes 20 de l'empilement d'interconnexion 18 et une couche supérieure permettant une bonne adhérence avec des éléments de connexion des puces rapportées ou avec des billes de soudure. Les plots 24A et 24B peuvent par exemple être obtenus en formant un empilement d'accrochage sur l'ensemble de la structure puis en définissant les régions 24A et 24B par gravure au travers d'un masque. Dans l'empilement d'interconnexion 18, des pistes et vias conducteurs sont prévus pour atteindre et connecter les plots 24A et 24B. Dans le cadre de la variante A, on a représenté à titre d'exemple une connexion 20-21 entre une région diffusée 12A et un plot 24A, une connexion 20-21 entre une région diffusée 13A, un TSV 16 et un plot 24B, une connexion 20-21 entre une région diffusée 14A, un TSV 16 et un plot 24B, et une connexion 20-21 entre une région diffusée 15A et un plot 24A. Dans le cadre de la variante B, on a représenté à titre d'exemple une connexion 20-21 entre une région diffusée 12B et un plot 24A, une connexion 20-21 entre une région diffusée 13B et un plot 24B, une connexion 20-21 entre une région diffusée 14B et un plot 24B, et une connexion 20-21 entre une région diffusée 15B et un plot 24A.

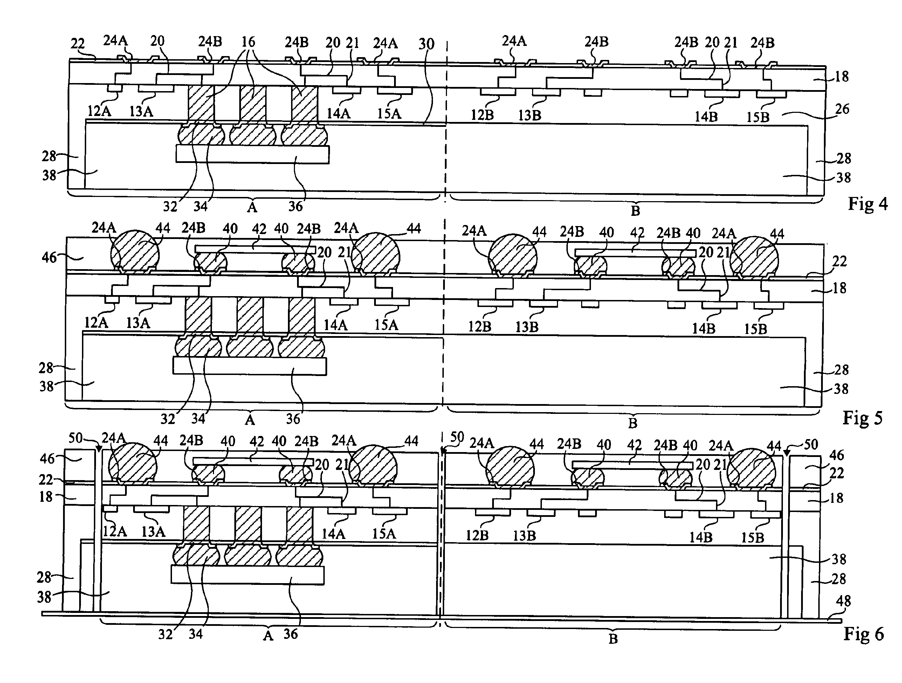

On notera que la couche 22, ainsi que les régions d'accrochage 24A et 24B, pourront être formées plus tard dans le procédé décrit ici, avant l'étape de la figure 5.

A l'étape illustrée en figure 2, on a aminci la tranche semiconductrice 10 pour former une couche semiconducteur 26 laissant apparaître, du côté de la variante A, le matériau conducteur des portions inférieures des tranchées conductrices 16. L'amincissement de la tranche 10 est réalisé de préférence sur une partie centrale seulement de la tranche 10, le contour de la tranche 28 conservant une épaisseur plus importante. L'amincissement de la tranche 10 est réalisé par meulage et/ou par polissage mécanique ou mécanochimique (CMP) et/ou par gravure humide (procédé chimique). Ainsi, la structure obtenue reste rigide du fait de cet anneau périphérique 28. On notera que l'on pourra prévoir des portions 28 différentes, formant diverses poutres de renforcement sous la surface de la couche 26, par exemple sur le contour de chaque puce individuelle ou d'un ensemble de puces individuelles. De telles structures de poutres de renforcement sont notamment décrites dans la demande de brevet FR 2771108 et ne seront pas décrites ici plus en détail. L'amincissement de la tranche 10 pourra être réalisé par une gravure anisotrope.

A l'étape illustrée en figure 3, on a formé, dans la variante A et sur la face inférieure de la couche semiconductrice 26, une couche de matériau isolant 30. On notera que la couche de matériau isolant 30 pourra, si les deux variantes A et B sont prévues sur une même tranche 10, s'étendre sur la face inférieure de la couche 26 dans la variante B. A titre d'exemple, la couche isolante 30 peut être en oxyde de silicium, en nitrure de silicium ou en un empilement de ces matériaux. La couche isolante 30 comprend des ouvertures en regard des tranchées conductrices 16 au niveau desquelles sont formées des régions conductrices d'accrochage 32. De la même façon que les régions d'accrochage 24A et 24B, les régions d'accrochage 32 peuvent être constituées d'un empilement de matériaux conducteurs permettant à la fois une bonne adhérence sur le matériau conducteur des tranchées 16 et un bon maintien des billes de soudure formées ensuite sur leurs surfaces.

A l'étape illustrée en figure 4, on a reporté des puces électroniques sur la face inférieure de la couche semiconductrice 26. Pour cela, des billes de soudure 34 sont formées sur les régions d'accrochage 32 et des puces électroniques 36 sont fixées par brasure sur les billes de soudure 34. Les puces rapportées 36 peuvent inclure de nombreux composants électroniques.

Les billes de soudure 34 peuvent avoir un diamètre compris entre 20 et 100 µm et les puces rapportées 36 avoir une épaisseur comprise entre 75 et 125 µm. On peut également reporter des puces 36 non pas par l'intermédiaire de billes de soudure mais par des fils de connexion (wire bonding), ou encore par tout autre moyen de connexion connu.

Ensuite, on a déposé une couche de résine épaisse 38 sur la face inférieure de la structure, de façon à remplir le volume de la tranche 10 éliminé à l'étape de la figure 2. De préférence, la couche 38 est formée par un moulage par compression, ce qui permet d'obtenir une couche 38 présentant une surface inférieure bien plane.

Pour que la résine 38 soit suffisamment rigide et résistante, on pourra choisir une résine époxy chargée. De plus, pour que la résine pénètre convenablement dans l'espace situé entre les puces rapportées 36 et la couche 30, les charges de la résine ont de préférence un diamètre inférieur à 20 µm. Pour assurer une bonne rigidité et une bonne évacuation de la chaleur produite par les composants électroniques, la résine 30 pourra avoir un module d'Young compris entre 3 et 10 GPa et un coefficient de dilatation thermique proche de celui du silicium.

A l'étape illustrée en figure 5, on a reporté des puces électroniques 42 sur les régions d'accrochage 24B. Pour cela, des billes de soudure 40 sont formées sur les régions d'accrochage 24B et les puces 42 sont fixées par brasure sur les billes de soudure 40. A titre d'exemple, les billes de soudure 40 peuvent avoir un diamètre compris entre 20 et 100 µm et les puces rapportées 42 avoir une épaisseur comprise entre 75 et 125 µm. La formation d'une structure telle que celle de la figure 5 permet d'obtenir une densité de composants par puce individuelle plus importante que lors de la formation de composants électroniques uniquement sur la tranche semiconductrice 10.

Des billes de soudure 44 de diamètre plus important, par exemple compris entre 150 et 300 µm, sont formées quant à elles sur les régions d'accrochage 24A. Une couche de résine 46 est ensuite formée sur la face supérieure du dispositif, la couche de résine 46 laissant libre une partie supérieure des billes de soudure 44 et recouvrant complètement l'empilement des billes 40 et des puces 42. Pour cela, la couche 46 peut avoir une épaisseur comprise entre 75 et 125 µm. La couche de résine 46 permet la protection de la face supérieure de la structure.

A l'étape illustrée en figure 6, on a fixé la structure de la figure 5 sur un papier ou une bande adhésive 48, du côté de sa face inférieure. Ensuite, les puces électroniques individuelles sont séparées les unes des autres, par exemple par sciage. Le sciage définit des espacements 50 sur l'ensemble de l'épaisseur du dispositif entre les puces individuelles. De façon classique, l'étape de la figure 6 pourra être suivie d'une étape de remplissage des ouvertures 50 d'une résine puis d'une redécoupe en puces individuelles, ceci permettant la protection des côtés des puces individuelles découpées et finalisant l'encapsulation. Les puces individuelles sont prêtes à être prises une par une pour montage sur une carte de circuit imprimé, ou autre.

Le procédé présenté ici est particulièrement adapté à la formation de puces électroniques à montage en surface, destinées à être fixées du côté de la face de la tranche semiconductrice sur laquelle sont formés les composants électroniques. Il est de plus particulièrement adapté pour des puces encapsulées dans lesquelles des puces de circuit électronique sont reportées sur la face avant de la tranche semiconductrice, mais également sur la face arrière de celle-ci. De plus, la formation de poutres de renforcement 28 sous la couche semiconductrice 26 permet d'éviter les phénomènes de gauchissement de cette couche semiconductrice.

On notera que le procédé décrit ici est susceptible de nombreuses variantes. Notamment, les divers matériaux décrits dans les différentes étapes de ce procédé ne sont pas limités aux exemples donnés ici.

## Revendications

1. Procédé d'encapsulation de composants électroniques, comprenant les étapes suivantes :
(a) former, dans et sur une première face d'une tranche semiconductrice (10), des composants électroniques et former des tranchées remplies de matériau conducteur (16) du côté de la première face de la tranche semiconductrice (10) ;
(b) former, sur la première face, un empilement d'interconnexion (18) comprenant des pistes (20) et vias conducteurs séparés par un matériau isolant ;
(c) former des premiers et deuxièmes plots (24B, 24A) d'accrochage sur l'empilement d'interconnexion ;
(d) amincir la tranche semiconductrice (10), excepté au moins sur son contour (28) de façon à laisser apparaître la face inférieure desdites tranchées (16), former des troisièmes plots d'accrochage (32) sur ladite face inférieure de la tranche semiconductrice, au niveau des tranchées remplies de matériau conducteur (16), et reporter des premières puces (36) sur les troisièmes plots d'accrochage ;
(e) remplir la région amincie d'une première couche de résine (38) ;
(f) reporter au moins une seconde puce (42) sur les premiers plots d'accrochage (24B) et former des billes de soudure (44) sur les deuxièmes plots d'accrochage (24A) ;
(g) déposer une seconde couche de résine (46) recouvrant les secondes puces (42) et recouvrant partiellement les billes de soudure (44) ;
(h) coller une bande adhésive (48) sur la première couche de résine (38) ; et
(i) découper la structure en puces individuelles.

2. Procédé selon la revendication 1, dans lequel la première couche de résine (38) contient des charges d'un diamètre inférieur à 20 µm.

3. Procédé selon la revendication 1 ou 2, dans lequel les premières et secondes puces (36, 42) sont fixées sur les régions d'accrochage correspondantes (32, 24B) par des secondes billes de soudure (34, 40).

4. Procédé selon la revendication 3, dans lequel les secondes billes de soudure ont un diamètre compris entre 20 et 100 µm.

5. Procédé selon l'une quelconque des revendications 1 à 4, dans lequel les premiers, deuxièmes et troisièmes plots d'accrochage sont constitués d'un empilement conducteur.

6. Procédé selon l'une quelconque des revendications 1 à 5, dans lequel l'étape (i) est suivie d'un décollage de la bande adhésive (48).

## Patentansprüche

1. Ein Verfahren zum Einkapseln elektronischer Bauteile, wobei das Verfahren die folgenden Schritte aufweist:
(a) Ausbilden innerhalb und auf einer ersten Oberfläche eines Halbleiter-Wafers (10) von elektronischen Bauteilen und Ausbilden von mit leitendem Material gefüllten Gräben (16) auf der Seite der ersten Oberfläche des Halbleiter-Wafers (10);
(b) Ausbilden auf der ersten Oberfläche des Wafers eines Zwischenverbindungsstapels (18), der leitende Bahnen (20) und Durchkontaktierungen bzw. Vias aufweist, die durch ein isolierendes Material getrennt sind;
(c) Ausbilden von ersten und zweiten Verbindungskontakten (24B, 24A) auf dem Zwischenverbindungsstapel;
(d) Dünnermachen des Halbleiter-Wafers (10) mit der Ausnahme wenigstens seiner Kontur (28), um die Unterseiten der Gräben (16) freizulegen, Ausbilden dritter Verbindungskontakte (32) an der Unterseite des Halbleiter-Wafers, und zwar auf dem Niveau der mit leitendem Material gefüllten Gräben (16) und Installieren erster Chips (36) an den dritten Verbindungskontakten;
(e) Füllen des dünnergemachten Bereichs mit einer ersten Harzschicht (38);
(f) Installieren wenigstens eines zweiten Chips (42) auf den ersten Verbindungskontakten (24B) und Ausbilden von Lötkontakten (44) auf den zweiten Verbindungskontakten (24A);
(g) Aufbringen einer zweiten Harzschicht (46), welche die zweiten Chips (42) abdeckt und die Lötkontakte (44) teilweise abdeckt;
(h) Bonden eines adhäsiven Streifens (48) an der ersten Harzschicht (38); und
(i) Aufteilen der Struktur in individuelle Chips.

2. Verfahren nach Anspruch 1, wobei die erste Harzschicht (38) Füllungen mit einem Durchmesser kleiner als 20 µm enthält.

3. Verfahren nach Anspruch 1 oder 2, wobei die ersten und zweiten Chips (36, 42) an den entsprechenden Verbindungsbereichen (32, 24B) durch zweite Lötkontakte (34, 40) befestigt sind.

4. Verfahren nach Anspruch 3, wobei die zweiten Lötkontakte einen Durchmesser im Bereich zwischen 20 und 100 µm besitzen.

5. Verfahren nach einem der Ansprüche 1 bis 4, wobei die ersten, zweiten und dritten Verbindungskontakte aus einem leitenden Stapel gebildet sind.

6. Verfahren nach einem der Ansprüche 1 bis 5, wobei nach dem Schritt (i) eine Trennung vom adhäsiven Streifen (48) erfolgt.

## Claims

1. A method for encapsulating electronic components, comprising the steps of:
(a) forming, inside and on top of a first surface of a semiconductor wafer (10), electronic components, and forming trenches filled with a conductive material (16) on the side of the first surface of the semiconductor wafer (10);
(b) forming, on the first surface of the wafer, an interconnection stack (18) comprising conductive tracks (20) and vias separated by an insulating material;
(c) forming first and second bonding pads (24B, 24A) on the interconnection stack;
(d) thinning down the semiconductor wafer (10), except at least on its contour (28) to expose the lower surface of said trenches (16), forming third bonding pads (32) on said lower surface of the semiconductor wafer, at the level of the trenches filled with conductive material (16), and installing first chips (36) on the third bonding pads;
(e) filling the thinned-down region with a first resin layer (38);
(f) installing at least one second chip (42) on the first bonding pads (24B) and forming solder bumps (44) on the second bonding pads (24A);
(g) depositing a second resin layer (46) covering the second chips (42) and partially covering the solder bumps (44);
(h) bonding an adhesive strip (48) on the first resin layer (38); and
(i) scribing the structure into individual chips.

2. The method of claim 1, wherein the first resin layer (38) contains loads having a diameter smaller than 20 µm.

3. The method of claim 1 or 2, wherein the first and second chips (36, 42) are attached on the corresponding bonding regions (32, 24B) by second solder bumps (34, 40).

4. The method of claim 3, wherein the second solder bumps have a diameter ranging between 20 and 100 µm.

5. The method of any of claims 1 to 4, wherein the first, second, and third bonding pads are formed of a conductive stack.

6. The method of any of claims 1 to 5, wherein step (i) is followed by a separation of the adhesive strip (48).
